# EUROPEAN PATENT APPLICATION

(11) **EP 3 849 109 A1**
(43) Date of publication of application: **14.07.2021**
(21) Application number: 20150820.7
(22) Date of filing: 08.01.2020
(51) Int. Cl.: H04H 60/41, H03J 1/00, H04H 60/51, H04H 20/63

(54) **A RADIO FREQUENCY SIGNAL PROCESSING DEVICE**

(71) Applicant: Unitron NV, 8970 Poperinge (BE)
(72) Inventor: GOEMAERE, Joris, 8480 Ichtegem (BE); VANBOSSEL, Gilles, 8800 Roeselare (BE); DELEU, Stephen, 9080 Beervelde (BE); JARKOVSKÝ, Ladislav, 51750 Castolovice (CZ); DALECKÝ, Roman, 53009 Pardubice (CZ)
(74) Representative: De Clercq & Partners

(57) **Abstract**

There is described a radio frequency signal processing device (10) and corresponding method (300) which automatically triggers an automatic scan routine (70) at power up when the channel configuration memory (100) is clear of and/or is set to be cleared of channel configuration data (80).

## Description

### FIELD

The invention is related to the technical field of radio frequency signal processing devices and methods of operating such radio frequency signal processing devices. More particularly to the processing and distribution of VHF or UHF signals such as for example terrestrial television or Digital Video Broadcast signals. Specifically, to the field of processing and distributing such radio frequency signals received by two or more terrestrial receiver antennas receiving two or more terrestrial radio frequency signals which have been received by over the air transmission from two or more different terrestrial broadcasting antennas at different geographic locations

### PRIOR ART

A known radio frequency processing device for distribution of television channels is described in EP2393291, which comprises a device for automatic identification and distribution of useful television channels by means of suitable programmable filters and equalization of the output levels. It is enough to press a start button of the device to perform the entire process automatically. However, such devices are typically mounted places that are difficult to reach, remote from the devices for receiving the signals they distribute. Even during installation, when for example the device is installed and subsequently all receiver devices are coupled thereto, the need to again gain access to the device at a location remote from the receiver devices for triggering this automatic process is not efficient and user friendly. Additionally, thus use of such buttons or other input elements for triggering such an automatic scan routine, requires sufficient technical knowledge of the user, for example for pressing the right button or issuing the right input commands to trigger the automatic scan routine. Such input elements are also typically prone to wear and thus provide for weak points in the cover of the device to shield it for example against humidity, especially, when for example mounted outdoors or in technical areas without climatization.

Therefor there exists a need for a more simple, user friendly, efficient and robust radio frequency signal processing device comprising such an automatic scan routine for detecting radio frequency channels.

### SUMMARY

According to a first aspect of the invention, there is provided a radio frequency signal processing device configured to:
- receive at least one radio frequency signal comprising at least one radio frequency channel; and
- output at least one output signal by processing at least one of the radio frequency channels of at least one of the received radio frequency signal by means of channel configuration data, the device comprising:
- a controller configured to trigger an automatic scan routine during which:
   - the radio frequency channels of the at least one radio frequency signal are automatically detected; and
   - corresponding channel configuration data is automatically generated for the detected radio frequency channels, and
- a channel configuration memory operatively connected to the controller and configured to store the channel configuration data generated during the channel scan routine,
   CHARACTERISED IN THAT
the controller is further configured such that:
- a channel memory check routine is automatically triggered when the device is powered up;
- the channel memory check routine is configured to:
   - detect whether the channel configuration memory is clear of and/or is set to be cleared of channel configuration data; and
   - trigger the automatic scan routine if it is detected that the channel configuration memory is clear of and/or set to be cleared of channel configuration data.

In this way a more simple, robust and user-friendly device is realized as the automatic scan routine is automatically triggered at power up of the device, without the need to manipulate any input element at the location where the device is installed as the channel memory check routine is automatically triggered.

According to an embodiment there is provided a radio frequency signal processing device or system configured to:
- receive at least one radio frequency signal comprising at least one radio frequency channel via at least one input connector;
- output at least one output signal comprising a set of radio frequency channels originating from the at least one radio frequency signal via at least one output connector; and
- receive power via at least one output connector;
the device or system comprising:
- a controller configured to trigger an automatic scan routine during which:
   - the radio frequency channels of the at least one radio frequency signal are automatically detected; and
   - for the detected radio frequency channels corresponding channel configuration data is automatically generated to generate the output signal;
- a channel configuration memory operatively connected to the controller and configured to store the channel configuration data generated during the channel scan routine,
wherein
the controller is further configured such that:
- a channel memory check routine is automatically triggered when the device or system is powered up;
- the channel memory check routine is configured to:
   - detect whether:
      - the channel configuration memory comprises any channel configuration data generated during a previous automatic scan routine; and/or
      - the channel configuration memory is clear of and/or is set to be cleared of channel configuration data; and
   - trigger the automatic scan routine if it is detected that:
      - the channel configuration memory does not comprise any channel configuration data generated during a previous automatic scan routine; and/or
      - the channel configuration memory is clear of and/or is set to be cleared of channel configuration data.

Such an embodiment is advantageous as such a signal processing device or system is embodied as a suitable signal distribution system which suitably selects and distributes the channels of the received radio frequency signal to the output signal. Such a signal distribution system is typically coupled into the system at a difficult to reach service area and/or close to the antenna, for example on the roof of a building. According to a particular embodiment, the radio frequency signals are received at the input connectors from the antennas by means of a suitable coaxial cable, and the output signal is also provided for further distribution via an output connector to a suitable coaxial cable. However, it is clear that alternative embodiments are possible, such as for example one or more output connectors 42 for providing optical signals, wired network signals, wireless network signals, etc. It is clear that according to such an embodiment, the device could also be embodied as a system of one or more suitably interconnected devices.

According to a further embodiment, there is provided a radio frequency signal processing device, wherein the radio frequency signal processing device further comprises at least one output connector and is further configured to:
- output said at least one output signal, as determined by means of the channel configuration data, via said at least one output connectors; and
- receive power via at least one of said at least one output connectors.

In this way the device can for example be remotely powered via power provided by a receiver device coupled an output connector of the device, without the need for providing a power source at the difficult to reach and/or remote location where the device is installed. In combination with the channel memory check routine being triggered at power up, this further increases the simplicity and efficiency of the installation of the signal processing device, as, as soon as the output connector is suitably coupled to a suitable receiver device which then provides the signal processing device with power via the output connector, this will power up the signal processing device and trigger the automatic channel memory check routine without the need for any manipulation or intervention at the remote or difficult to reach location of the signal processing device.

According to a further embodiment, the radio frequency signal processing device is further configured to:
- output at least one output signal comprising a set of the radio frequency channels originating from the at least one radio frequency signal via at least one output connector.

Such an embodiment of the signal processing device, which functions as a signal distribution device, which automatically detects and distributes a set of radio frequency channels of the received radio frequency channels, is user friendly and can be installed efficiently, as it does not require any user manipulation before its first use. Powering up the signal processing device suffices to trigger the channel memory check routine in order to arrive at a fully functional device outputting one or more desired output signals based on the detected radio frequency channels in the received radio frequency channels.

According to an embodiment, there is provided a radio frequency signal processing device, wherein the controller is further configured such that:
- the channel memory check routine is further configured not to trigger the automatic scan routine if it is detected that the channel configuration memory does is not clear of and/or is not set to be cleared of channel configuration data.

In this way the device still performs efficiently as the automatic scan routine is not performed at every power up of the device, but only when necessary.

According to a further embodiment, there is provided a radio frequency signal processing device, wherein the controller is further configured such that:
- the channel memory check routine is further configured not to trigger the automatic scan routine if it is detected that the channel configuration memory is not clear of and/or is not set to be cleared of channel configuration data; and/or is not clear of and/or is not set to be cleared of and/or does comprise channel configuration data generated during a previous automatic scan routine.

According to a further embodiment, there is provided a radio frequency signal processing device, wherein the radio frequency signal processing device is configured to receive a plurality of radio frequency signals and in which the controller is configured to generate at least one output signal comprising a set of radio frequency channels originating from two or more radio frequency signals.

In this way the device automatically makes available the channels of a plurality of RF signals in a simplified and automated way.

According to a further embodiment and/or aspect of the invention, there is provided a radio frequency signal processing device, wherein the radio frequency signal processing device is configured to:
- detect the bandwidth and/or centre frequency of a plurality of the radio frequency channels of one or more of the radio frequency signals during the automatic scan routine; and
- determine the channel spacing and/or the corresponding frequency plan and/or the corresponding ITU Region based on the detected bandwidth and/or centre frequency of a plurality of the radio frequency channels. According to a further embodiment and/or aspect of the invention there is provided a radio frequency signal processing method comprising the steps of:
- detecting the bandwidth and/or centre frequency of a plurality of the radio frequency channels of one or more of the radio frequency signals during the automatic scan routine; and
- determining the channel spacing and/or the corresponding frequency plan and/or the corresponding ITU Region based on the detected bandwidth and/or centre frequency of a plurality of the radio frequency channels.

As different geographic regions are covered by different frequency plans, prior art radio signal processing devices had to be pre-configured or manually set to operate according to the frequency plan of the particular geographic region of interest. Additionally, when such frequency plans are adjusted over time, all devices already produced will be configured with an outdated frequency plan. This limits the flexibility of use of such devices, when for example distributed by means of a world-wide sales channel. In order to overcome this drawback, the proposed solution of detecting the bandwidth and/or centre frequency of a plurality of radio frequency channels allows to check the compatibility of the detected bandwidth and/or centre frequencies of a plurality of radio frequency channels, the channel spacing or a multiple of this channel spacing can be determined between such a plurality of radio frequency channels, and further correspondence with a particular frequency plan or ITU region can be determined.

According to a preferred embodiment, there is provided a radio frequency signal processing device, wherein the radio frequency signal processing device is configured to generate an output signal of which the channel spacing and/or the frequency plan is equal to and/or compatible with said determined channel spacing and/or the corresponding frequency plan and/or the corresponding ITU Region.

This allows the device to automatically and flexibly detect the frequency plan and/or geographic region where it is put to use, which can for example assist in the generation of an output signal that is compatible with receiver devices configured to operate in such a frequency plan and/or geographic region.

According to a further embodiment, there is provided a radio frequency signal processing device, wherein the controller is further configured to trigger a channel memory clear routine during which the channel configuration data is removed from the channel configuration memory upon reception of a channel memory clear signal.

In this way a subsequent new execution of the automatic scan routine can be triggered in a flexible way, for example at the next power up of the device.

According to a further embodiment, there is provided a radio frequency signal processing device, wherein the radio frequency signal processing device comprises, operatively coupled to the controller:
- non-volatile storage memory comprising the channel configuration memory;
- working memory configured to store a copy of the channel configuration memory for use by the controller during generation of the output signal.

In this way, advantageously, the channel configuration memory can be modified without impacting the operation of the controller during generation of the output signal.

According to a further embodiment, there is provided a radio frequency signal processing device, wherein the controller is configured, upon receipt of a channel memory clear signal, to trigger a channel memory clear routine configured to:
- remove the channel configuration data from the channel configuration memory in the non-volatile storage memory; and
- retain the copy of the channel configuration memory in the working memory thereby allowing the controller to continue the generation of the output signal.

In this way a new automatic scan routine can be prepared for the next power up of the device, while the controller is able to make continued use of the previous channel configuration data.

According to a further embodiment, there is provided a radio frequency signal processing device, wherein the controller is further configured to, upon receipt of a forced channel memory clear signal, to trigger a forced channel memory clear routine configured to:
- trigger the automatic scan routine thereby generating and storing new channel configuration data in the channel configuration memory;
- replace the copy of the channel configuration memory in the working memory with the new channel configuration data of the channel configuration memory, thereby allowing the controller to generate of the output signal with the new channel configuration data.

In this way also a new automatic scan routine can be performed in a flexible way, without needing to wait for the next power up of the device.

According to a further embodiment, there is provided a radio frequency signal processing device, wherein the controller is further configured to receive the channel memory clear signal and/or the forced channel memory clear signal from one or more of the following:
- one or more input elements of the radio frequency signal processing device;
- one or more signals received from a receiver device when coupled to the radio frequency signal processing device;
- one or more signals received from a suitable remote device via a network, preferably a low power wide area network.

In this way the automatic scan routine can be triggered in a flexible way, and for example from a remote location.

According to a further embodiment, there is provided a radio frequency signal processing device, wherein radio frequency signal processing device is configured to generate the channel memory clear signal and/or forced channel memory clear signal by means of a predetermined power cycle pattern comprising a predetermined pattern of a plurality of predetermined power up and/or power down cycles of the radio frequency signal processing device.

In this way the automatic scan routine can be triggered without the need for any input elements.

According to a further embodiment, there is provided a radio frequency signal processing device, wherein the radio frequency signal processing device comprises:
- the at least one input connector; and
- the at least one output connector configured to output the at least one corresponding output signal, and
   wherein the radio frequency signal processing device is configured to receive power via the at least one output connector from a device when coupled to said output connector.

In this way the device can be remotely powered, thereby simplifying its installation and further the power up and/or power cycle of the device can be performed remotely at the device providing power to the output connector.

According to a further embodiment, there is provided a radio frequency signal processing device, wherein, automatic scan routine is further configured to trigger a collision resolution routine when a plurality of colliding channels is detected at a same channel location in a plurality of radio frequency signals, whereby the collision resolution routine is configured to generate channel configuration data such that at least two of the colliding channels at a single channel location in the radio frequency signals are provided at different channel locations of the set of radio frequency channels of the output signal.

In this way colliding channels can be handled in a simple, efficient and flexible way, without losing any of the colliding channels in the output signal.

According to a further embodiment, there is provided a radio frequency signal processing device, wherein the collision resolution routine is further configured such that at least one of the colliding channels is provided at an unused channel location and/or a deprecated channel location of the set of radio frequency channels of the output signal.

In this way colliding channels can be reallocated efficiently.

According to a further embodiment, there is provided, a radio frequency signal processing device, according to any of the preceding claims, wherein the radio frequency signal processing device is further configured to output at least one antenna alignment feedback signal, and wherein the controller is further configured to trigger an antenna alignment feedback routine during which at least one antenna alignment feedback signal is output which is configured to indicate the power level and/or signal quality of at least one detected radio frequency channel of at least one of the received radio frequency signals and/or changes of said power level and/or signal quality.

In this way, especially during installation of the radio frequency signal processing device in the proximity of the receiver antenna, the orientation of the receiver antenna can be adjusted efficiently and reliably.

According to a further embodiment, there is provided a radio frequency signal processing device, wherein the radio frequency signal processing device does not comprise any input element configured to be manually operated.

In this way a simple and robust device is realized, which can be installed efficiently.

According to a further embodiment, there is provided a radio frequency signal processing device, wherein the radio frequency signal processing device is configured to receive, from two or more terrestrial antennas, two or more terrestrial radio frequency signals comprising a UHF frequency range comprising a plurality of UHF channels with different power levels which have been transmitted over the air by different terrestrial broadcasting stations.

Especially in such terrestrial UHF signals, there are large differences in power levels, and such a simplified and robust device is advantageous for making all these UHF channels from different RF sources available in an output signal at a desired power level.

According to a further aspect of the invention, there is provided a method of operating a radio frequency signal processing device according to any of the preceding claims, wherein the device is configured to receive power via at least one of said output connectors, whereby the method comprises the steps of:
- receiving at least one radio frequency signal comprising at least one radio frequency channel;
- triggering an automatic channel scan routine during which:
   - the radio frequency channels of the at least one radio frequency signal are automatically detected; and
   - automatically generating, for the detected radio frequency channels, corresponding channel configuration data to generate at least one output signal;
- storing the channel configuration data generated during the automatic channel scan routine in a channel configuration memory; and
- outputting the at least one output signal by processing at least one of the radio frequency channels of at least one of the received radio frequency signal by means of channel configuration data,
   CHARACTERISED IN THAT
the method comprises the further steps of:
- automatically triggering a channel memory check routine when the device is powered up;
- the channel memory check routine comprising the steps of:
   - detecting whether the channel configuration memory is clear of and/or is set to be cleared of any channel configuration data generated; and
   - triggering the automatic scan routine if it is detected that the channel configuration memory is clear of and/or is set to be cleared of any channel configuration data.

It is clear that further embodiments of the method are possible comprising steps similar as the corresponding functional features of the embodiments of the device described above and/or in the dependent claims.

### BRIEF DESCRIPTION OF THE DRAWINGS

- Figure 1 shows an exemplary embodiment of a radio frequency signal processing device according to the invention;
- Figure 2 shows the embodiment of Figure 1 in further detail;
- Figure 3 shows an embodiment of a method of operating an embodiment of the device according to Figure 1 or Figure 2;
- Figure 4 shows an embodiment of a terrestrial RF signal comprising a plurality of UHF channels received by over the air transmission;
- Figure 5A to Figure 5D show embodiments of the RF signals received and output by the device according to Figure 1 or Figure 2;
- Figure 6 shows an embodiment of channel configuration data;
- Figures 7 and 8 show alternative embodiments of the radio frequency signal processing device; and
- Figure 9 shows an embodiment of computing device suitable for executing the method of Figure 3.

### DESCRIPTION

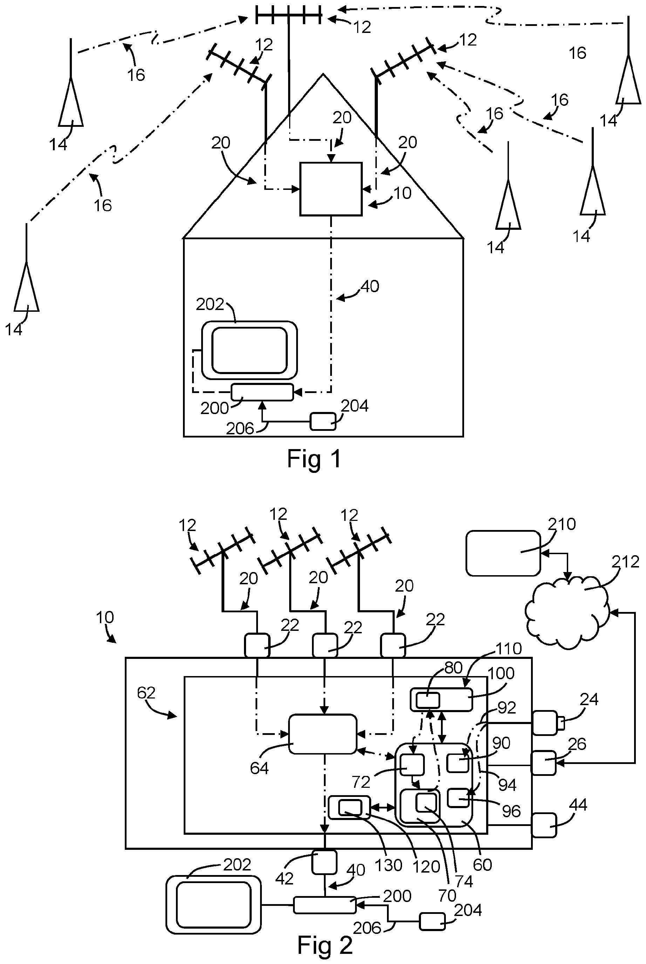

An embodiment of a radio frequency signal processing device 10 is for example shown in Figure 1. According to the embodiment shown, the device 10 is for example arranged at or near the roof of a house 1, which can be generally be referred to as a residency type that is referenced as a single family unit or SFU. It is however clear that alternative embodiments are possible in which the device 10 is used in the context of residency types referred to as multiple dwelling units or MDU, such as for example apartment buildings comprising a plurality of apartments, or any other suitable residency type comprising shared services for a plurality of dwelling units.

According to the embodiment shown in Figure 1, the radio frequency signal processing device 10 configured to receive three radio frequency signals 20, or RF signals 20. It is clear that alternative embodiments are possible in which the device receives another number of RF signals 20, for example one, two, four, five or more, ..., as long as in general the device 10 receives at least one RF signal 20. As will be described in further detail below, the device 10 is particularly advantageous when it receives a plurality of RF signals 20.

According to the embodiment shown, the device 10 is configured to receive these three RF signals 20 from three terrestrial antennas 12. As shown, the RF signals 20 received by the three antennas 12 are received from five different terrestrial broadcasting stations 14 by means of over the air transmission 16. It is thus clear that each terrestrial antenna 12 receives an RF signal 20 which has been transmitted by over the air transmission from at least one terrestrial broadcasting stations 14. These terrestrial broadcasting stations 14 are thus configured to transmit the RF signal by means of a suitable transmission antenna for over the air transmission from the location of the broadcasting station 14. As such, it is clear that, a plurality of these broadcasting stations 14, could thus be located at different geographic locations. Further these broadcasting stations 14 could each make use of a different set of RF frequency ranges and/or modulation standards and/or transmission techniques for the over the air transmission of the terrestrial RF signals 20. In this way, as shown, in order to receive the RF signals transmitted by such a plurality of different broadcasting stations 14, it might be needed to make use of a plurality of different terrestrial receiver antennas 12, which for example are optimized to receive RF signals that have been transmitted from a particular geographic location, such as for example directional antenna, etc. , or from one or more particular frequency ranges, such as for example UHF, VHF, etc. , or in accordance to a particular transmission standard or technique, such as for example DVB-T, analog transmission techniques, etc.

According to the embodiment shown in Figure 1, and as will be explained in further detail below with reference to Figure 1 to Figure 6, the device 10 is configured to receive three RF signals 20 comprising at least one radio frequency channel 30 or RF channel 30 and to output an output signal 40 comprising a set 52 of radio frequency channels 50 originating from these three RF signals 20. According to a particular embodiment, for example, the terrestrial RF signals 20 input to the device 10 for example comprise a UHF frequency range comprising a plurality of UHF channels 30. As will be explained in further detail below, a plurality of these RF channels 30 of such a terrestrial RF signal 20 will arrive from the terrestrial antennas 12 with different power levels, particularly when these RF channels 30 have been transmitted over the air by different terrestrial broadcasting stations 14. Preferably, as will be described in further detail below, the device 10 is configured to re-arrange and adjust the RF channels 30 from the RF signals 20 in such a way that all the desired RF channels 50 are present in the output signal 40 at a desired signal level, even when for example a plurality of colliding RF channels 30 are present in two or more RF signals 20.

It is clear that according to the embodiment shown in Figure 1, the device 10 is embodied as a single or unitary product, unit, module, .... It is however clear that alternative embodiments are possible in which the device or system 10 comprises any suitable plurality of products, units, modules, ... and/or comprised of a plurality of distinct components which are suitably coupled.

As further shown, in more detail in Figure 2, which shows the embodiment of the device 10 of Figure 1 in further detail, the device 10 comprises a suitable controller 60. Such a controller 60 could for example be part of, coupled to and/or at least partly integrated in a suitable signal processing circuit 62, which comprises suitable elements for the analog and/or digital processing of the received RF signals 20 to generate the output signal 40. According to the embodiment shown, the RF signals 20 received from an antenna 20 are provided to a single input connector 22 for input to the signal processing circuit 62. According to the embodiment shown, this thus means that there are provided three input connectors 22 for the input of three corresponding RF signals 20. It is however clear that alternative embodiments are possible with at least one, a plurality, such as for example one, two, three, four or more input connectors 22 for a corresponding number of RF signals 20. According to the embodiment shown in Figure 2, it is further clear that the output signal 40 generated by the signal processing circuit 62 is output via a single output connector 42. It is however clear, that also here, alternative embodiments are possible in which there are generated a plurality of output signals 40, such as for example two, three, four or more output signals 40 by the signal processing circuit 62.

As further shown in Figure 2, the controller 60 is configured to automatically trigger an automatic scan routine 70. During such an automatic scan routine 70 the radio frequency channels 30 of the RF signals 20 are automatically detected. Then the automatic scan routine 70 continues with the automatic generation of channel configuration data 80 for the detected radio frequency channels 30 corresponding. As will be explained in further detail below, this channel configuration data 80 will then be used to generate the output signal 40. As further shown, the device 10 further comprises a channel configuration memory 100, which according to the embodiment shown is for example part of, coupled to and/or at least partly integrated in the signal processing circuit 62. As shown, the channel configuration memory 100 is operatively connected to the controller 60. The channel configuration memory 100 is configured to store the channel configuration data 80 generated during the channel scan routine 70. It is clear that, once the channel configuration data 80 has been generated by the automatic scan routine 70 and is then stored in the channel configuration memory 100, that then subsequently this stored channel configuration data 80 can be used by the controller 60 and/or other elements of the signal processing circuit 62 for the generation of the output signal 40 comprising the desired set of suitably processed RF channels 50.

As further shown, according to the embodiment of Figures 1 and 2, the device 10 is configured to provide the output signal 40 to a suitable receiver device 200, which, according to the embodiment shown, is suitable coupled to the output connector 42 of the device 10, for example by means of a suitable cable such as for example a coaxial cable, a suitable network cable, such as for example an ethernet cable, etc. Such a receiver device, typically also referred to as integrated receiver device 200 or IRD, receives the output signal 40 for provision of the RF channels 50 present in the output signal 40 to an end user device 202, such as for example a television set, etc. According to the embodiment shown, the receiver device 200 is suitably coupled to a single end user device 202, however, it is clear that alternative embodiments are possible in which the receiver device 200 can be coupled to a plurality of end user devices, and/or a plurality of such receiver devices 200 can be coupled to an output connector 42 of the device 10. The receiver device 200 could for example be a device that is suitably coupled to an end user device, such as in the embodiment shown in Figures 1 and 2, however it is clear that alternative embodiments are possible in which the receiver device 200 is for example part of, coupled to and/or at least partly integrated in the end user device 202. It is however clear that alternative embodiments are possible, in which for example the device 10 is suitably coupled to any other suitable device 200 for receiving and/or further distributing the output signal 40 received from the output connector 42, such as for example a suitable device 200 for receiving the output signal 40 from the output connector 42 and subsequently distributing it to one or more, a suitable plurality, etc. of further devices such as receiver devices, end user devices, further distributing devices, etc. configured to receive the output signal 40. As will be explained in further detail below, the device 200 coupled to the output connector 42 is for example coupled to said output connector 42 by means of a suitable cable, such as for example a coaxial cable, also referred to as a coax cable, or any other suitable cable for the distribution of the output signal comprising a set of radio frequency channels 50 originating from the at least one radio frequency signal 20 via at least one output connector 42.

It is further clear, as shown in the embodiment of Figures 1 and 2, that the device 10 is configured to receive power via the output connector 42. As shown, according to this embodiment with a single output connector 42, the device 10 is for example configured to receive power via the output connector 42 from the device 200 suitably connected to the output connector 42. It is well known to person skilled in the art, for example to provide, in addition to RF signals exchanged, for example via the output connector 42 to the device 200, to also receive power via the output connector 42 from the device 200, for example by means of a suitable DC voltage level and/or current provided to the output connector 42 by the device 200 when coupled to this output connector 42 by means of a suitable cable, such as for example a coax cable. As shown, the device 200, which for example is a suitable receiver device 200, is for example provided by power 206 from a suitable power supply 204. It is however clear that alternative embodiments are possible, in which for example the device comprises a plurality of output connectors 42 and/or in which each output connector 42 is suitably coupled to one or more devices 200. In general, according to such alternative embodiments, it suffices that the device is configured to receive power via at least one of the output connectors 42, and/or that, the device is configured to receive power 206 from at least one of the devices 200 via said at least one output connector 42, when coupled to said at least one output connectors 42. This is advantageous as in this way the device 10 can be remotely powered by the device coupled to the output connector 42, which does not necessitate the device 10 to be provided with an own power supply at the location where the device 10 is installed. This increases flexibility for the installation of the device 10, which can for example be installed in a remote location, different from the location of the devices 200 receiving the output signal 40, such as for example, as shown in Figure 1 in another place or room of the housing unit, such as for example in a service area, close to the antennas 12, without the need for a power outlet to be available at this remote location. However, as shown, according to the embodiment of Figure 1, optionally and/or additionally the device 10 could be provided with a further power supply connector or interface 44, separate from the output connectors 42, and configured to receive power from a power supply when coupled to this power supply connector 44. According to such an embodiment, the device could additionally and/or instead of being powered via the output connector 40 also be powered, for example by means of the dedicated power supply, via the power supply connector 44. In this way the device 10 can be provided with power, for example in case when the receiver devices coupled to the output connector 42 are not suitable for providing the device 10 with power via the output connector 42 and/or when the installation of a power supply at the location of the device 10 is possible and/or desirable. It is clear that still further embodiments are possible, in which for example the power supply connector 44 for providing power to the device 10 is not a dedicated power supply connector or interface, but is for example a connector, interface or any other suitable element for receiving and/or outputting suitable signals, similar as for example connector or interface 26, which is also suitable for providing the device with power, such as for example a suitable power over ethernet device, a battery, etc. According to still a further alternative embodiment, additionally or instead of the above options for providing the device 10 with power, it is clear that still further options are possible such as for example via any suitable connector, interface or other suitable element configured to receive power from a wired or wireless power supply system and/or wired or wireless charging system.

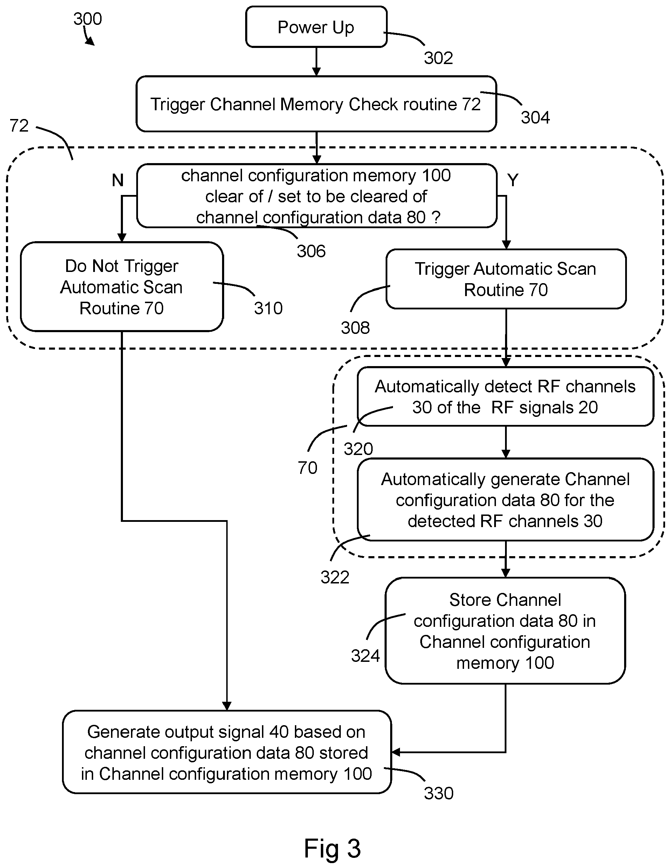

Advantageously, according to the embodiment shown in Figure 1 to Figure 3, the controller 60 is further configured such that a channel memory check routine 72 is automatically triggered when the device 10 is powered up, such as for example shown in step 304 of the embodiment of Figure 3. This means, as for example schematically shown in the embodiment of the method 300 of operating device 10 of Figure 3, when in step 302 the device 10 is for example powered up, the device 10 for example proceeds from an unpowered state, in which it is not supplied with power, and/or in which the controller 60 is put in an unpowered mode, deactivated mode, reset mode, sleep mode, etc. such that the device 10, at least temporary, does not generate the output signal 40, to a powered state in which it is supplied with power and/or in which the controller 60 is put in a powered mode, activated mode, operating mode in which it is functionally operative to generate an output signal 40. When powered up in step 302 and after automatically triggering the channel memory check routine 72 in step 304, as shown, the embodiment of the channel memory check routine 72 is executed by proceeding to step 306. Although according to some embodiments , the channel memory check routine 72 could be executed immediately after being triggered automatically in step 304, it is clear that alternative embodiments are possible, in which, after automatically triggering the channel memory check routine 72 in step 304, a predetermined set of other steps and/or operations is performed by the controller 60, for example related to a predetermined set of operations performed after a power up of the device 10, before the controller 60 proceeds to the execution of the channel memory check routine 72, by for example proceeding to step 306. It is further clear that in the context of this description, triggering a routine, such as the channel memory check routine, etc. should be interpreted as automatically triggering such a routine, in other words, without the need for an operator to provide a suitable input signal for example by manipulating a suitable manual input element such as for example a button, etc., unless otherwise specified.

When the channel memory check routine 72 is triggered and subsequently executed, it will, according to the embodiment shown in Figure 3, in step 306 detect whether the channel configuration memory 100 is clear of channel configuration data 80. According to a particular embodiment it is for example detected whether the channel configuration memory 100 is clear of channel configuration data 80. According to a further particular embodiment it is for example detected whether the channel configuration memory is clear of example channel configuration data 80 generated during a previous automatic scan routine 70. It is clear that according to particular embodiments, the channel configuration memory 100 is clear of channel configuration data 80, when the channel configuration data 80 has been cleared, erased, delete, removed, ... from the channel configuration memory 100, or when the channel configuration memory 100 does not or no longer comprises such channel configuration data 80. According to such embodiments, additionally and/or alternatively, during step 306, there is detected whether the channel configuration memory 100 is set to be cleared of channel configuration data 80. This could for example mean that a suitable memory clear flag, signal, trigger, status register, ... or any other suitable value that acts as a signal for a suitable function or process, which when set, loaded, activated, ... subsequently triggers a suitable memory clear function or process configured to clear the channel configuration data 80 of the channel configuration memory 100 during and/or after power up of the device 10. According to the embodiment shown, in step 308, the channel memory check routine 72 will then trigger the automatic scan routine 70 if it is detected that the channel configuration memory 100 is clear of and/or is set to be cleared of channel configuration data 80. Typically, this means that the channel memory check routine 72 will trigger the automatic scan routine 70 if it is detected that the channel configuration memory 100 does not comprise any channel configuration data 80. However it is clear that, alternative embodiments are possible, in which for example predetermined channel configuration data with respect to one or more particular radio frequency channels could be present in the channel configuration memory 100, which was not generated by means of a previous automatic scan routine 70, but was for example loaded and/or stored in the channel configuration memory 100 as standard preloaded channel configuration data for at least one standard predetermined radio frequency channel, which is for example preloaded or stored in to the channel configuration memory 100, for example as part of fallback channel configuration data in case the automatic scan routine 70 fails to automatically detect any RF channels 30 in the RF signals 20, etc. In such a case the automatic scan routine 70 will for example be triggered when it is detected that the channel configuration memory 100 is clear of and/or set to be cleared of channel configuration data 80 generated during a previous channel scan routine 70. However, it is clear that, in general, also alternative embodiments are possible in which for example the automatic scan routine 70 is triggered if it is detected that the channel configuration memory 100 does not comprise any channel configuration data 80, irrespective of whether this channel configuration data 80 was generated during a previous automatic scan routine 70.

As further shown, according to the embodiment of Figure 3, in step 310, the channel memory check routine 72 will not trigger the automatic scan routine 70 if it is detected that the channel configuration memory 100 is not clear of and/or set to be cleared of channel configuration data 80. According to such an embodiments, the automatic scan routine 70 will not be triggered by the channel memory check routine 72 when the channel configuration memory 100 does comprise channel configuration data 80, for example channel configuration data 80 generated during a previous automatic scan routine 70. It is clear that, according to the embodiment shown in Figure 3, the device 10 can proceed immediately to step 330 of the method, and make use of the channel configuration data 80 as present in the channel memory 100 to generate the output signal 40, without the need to execute the automatic scan routine 70. It is clear that also here alternative embodiments are possible in which the channel memory check routine 72 is further configured not to trigger the automatic scan routine 70 if it is detected that the channel configuration memory 100 does comprise channel configuration data 80, or is not clear of and/or set to be cleared of channel configuration data 80, irrespective of whether this channel configuration data 80 was generated during a previous automatic scan routine 70.

As further shown, according to the embodiment of Figure 3, when in step 308 the automatic scan routine 70 is triggered by the channel memory check routine 72, the method will proceed to the execution of the automatic scan routine 70 by proceeding to step 320, in which the controller 60 automatically detects the radio frequency channels 30 of the at least one radio frequency signal 20. It is clear to a skilled person that such an automatic detection of channels as present in the RF signals 20 received by the device 10 can be performed by means of any suitable method, such as for example comparing the power level of predetermined frequency ranges corresponding to one or more particular RF channels with a suitable threshold, etc.

As further shown in Figure 3, according to the embodiment shown, the automatic scan routine 70 proceeds with step 322, in which for the detected radio frequency channels 30 corresponding channel configuration data 80 is automatically generated to generate the output signal 40. As will be explained in further detail below, the channel configuration data 80 could comprise any suitable configuration data for the device 30 to transform the at least one detected RF channels 30 in at least one of the at least one received RF signals 20 into suitable set 52 of RF channels 50 for the output signal 40. Such channel configuration data 80 could for example comprise RF channel allocation data configured to select and/or transform, for example by means of a suitable frequency translation operation the RF channels 30 of the received RF signals 20 to a suitable location in the frequency spectrum for the set 52 of RF channels 50 of the output signal 40. However it is clear that alternative embodiments are possible in which, for example additional and/or alternative channel configuration data 80, is possible, such as for example also explained in further detail below, channel configuration data 80 related to the desired amount of adjustment of the signal level of the RF channels 30 in the received RF signals 20 for the generation of the set of channels 50 of the output signal 40.

As further shown, according to the embodiment of Figure 3, the controller 60 can then proceed to step 324, in which the channel configuration data 80 is automatically generated during the channel scan routine 70 is stored in the channel configuration memory 100. As for example also shown in Figure 2, it is clear that such a channel configuration memory 100 is operatively connected to the controller 60, which means that the channel configuration memory 100 could for example be coupled to and/or at least partly comprised within the controller 60 of the device 10.

Preferably as shown, in the embodiment of Figure 1 and 2 the radio frequency signal processing device 10 is configured to receive a plurality of radio frequency signals 20. Although, as shown in the embodiment of Figure 1 and 2, the controller 60 is configured to generate one output signal 40, according to alternative embodiments the controller 60 could be configured to generate a plurality of output signals 40. Preferably such output signals 40 comprise a set 52 of radio frequency channels 50 originating from the RF channels 30 of two or more RF signals 20 received by the controller 60, as in this way the RF channels 30 from for example different input connectors 22 received from for example different terrestrial antennas 12 can be distributed to a receiver device 200 in an optimized way.

According to the embodiment shown in Figures 1 and 2, the embodiment of device 10 receives three RF signals 20. It is however clear that according to alternative embodiments a different number of RF signals could be received by device 10, as long as in general the device 10 receives one or more, for example one, two, three, four, five or more, RF signals, however the device 10 is particularly advantageous when receiving a plurality of RF signals, this means two or more RF signals 20. According to this embodiment, these RF signals 20 are terrestrial RF signals received by terrestrial antennas 12 which have been transmitted over the air 16 by one or more terrestrial transmission antenna 14, for example by a terrestrial television broadcasting service. Such a terrestrial RF signal could for example comprise a DVB-T signal or Digital Video Broadcasting - Terrestrial signal, which is the DVB European-based consortium standard for the broadcast transmission of digital terrestrial television that was first published in 1997; or a DVB-T2 signal or Digital Video Broadcasting - Second Generation Terrestrial signal, which is the extension of the television standard DVB-T, issued by the DVB consortium, for the broadcast transmission of digital terrestrial television. Digital Video Broadcasting or DVB is a suite of internationally accepted open DVB standards for digital television, which are maintained by the DVB Project, an international industry consortium, and are published by a Joint Technical Committee or JTC of the European Telecommunications Standards Institute or ETSI, European Committee for Electrotechnical Standardization or CENELEC and European Broadcasting Union EBU.

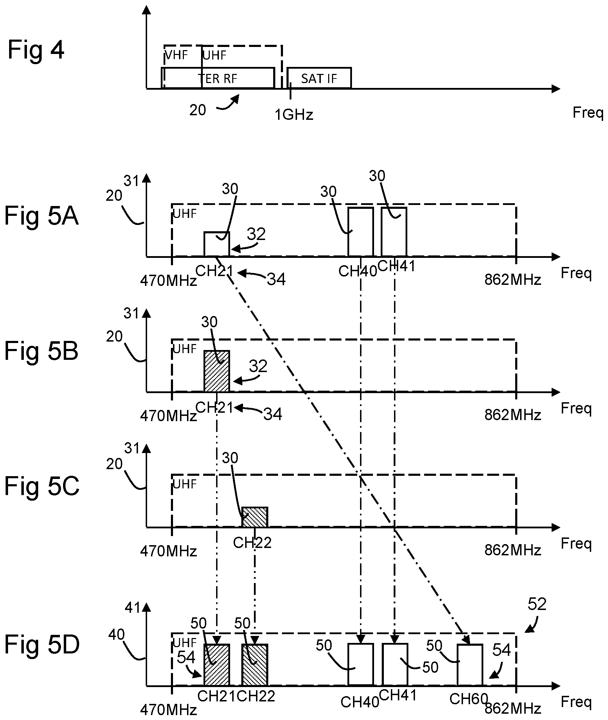

It is clear that terrestrial RF signals 20, which have been transmitted by over the air transmission 16, such as DVB-T or DVB-T2 in the context of this description are different from other signals originating from other sources than terrestrial radio frequency broadcasting services. RF signals 20 from such other sources could for be satellite signals, such as for example DVB-S signals or Digital Video Broadcasting - Satellite signals according to the DVB standard for Satellite Television. Such satellite broadcasted RF signals typically are in a much higher frequency band than terrestrial RF signals. Satellite signals are for example typically broadcasted in the C-band 4-8 GHz, Ku-band 12-18 GHz, etc, while terrestrial RF signals comprise a UHF frequency range. The Ultra High Frequency range or UHF frequency range is defined by the ITU or International Telecommunication Union as the range between 300 MHz and 3 GHz. The UHF frequency range is defined by IEEE as 0,3 GHz to 1 GHz. However, it is clear that in the context of this application, when referring to a terrestrial RF signal comprising terrestrial UHF signal, there is generally referred to a UHF frequency range which is lower than 1GHz, such as for example schematically shown in Figure 4. In the context of this description, when in general referring to an RF signal comprising a UHF frequency range and comprising a plurality of UHF channels 30, it is clear that this refers to embodiments similar to a terrestrial UHF signal, such as for example a terrestrial video broadcast signal, a terrestrial television broadcast signal, an analogue or digital terrestrial video broadcast signal, a DVB-T signal, a DVB-T2 signal, etc. which are operated worldwide in a UHF frequency range lower than 1GHz, for example in the range of 470MHz to 862MHz, such as for example shown in Figure 5A to Figure 5D. It is clear that alternative embodiments of terrestrial RF signals 20 comprising alternative suitable frequency ranges are possible, such as for example a frequency range lower than 950MHz or lower than 900MHz. As generally known to the man skilled in the art such a terrestrial UHF RF signal 20 comprises a UHF frequency range, typically comprising one or more predetermined UHF channels 30. In the context of this description of terrestrial broadcasting services, such a UHF channel or UHF frequency channel 30 is a designated radio frequency or a corresponding wavelength, assigned by a competent frequency assignment authority, such as for example the ITU, for the operation of particular analog or digital terrestrial television, video, radio, etc. terrestrial broadcasting stations. As shown in Figure 1, terrestrial antennas 12 will typically receive at least one such a terrestrial RF signal 20 comprising a plurality of UHF channels 30 with considerable variation in the signal level, quality, etc. for different UHF channels assigned to different terrestrial broadcasting stations 14, as the broadcasting power, transmission distance, signal interference, etc. varies for different terrestrial broadcasting stations 14. A terrestrial receiver antenna 12 could for example be located at a distance of 5km from a first terrestrial broadcasting station and at 50km from a second terrestrial broadcasting station. When for example both terrestrial broadcasting stations 14 transmit their respective UHF channels at the same signal power level, it is clear that there will be differences in the power level 31 of the received respective UHF channels 30 at the terrestrial receiver antenna 12, because of the difference in the transmission distance of the respective UHF channels 30. It is clear that for a plurality of different antenna 12, which for example are designed, oriented, etc. to receive such terrestrial RF signals 20 from still further different terrestrial transmission stations 14 via over the air transmission 16, that these variations in power level 31 of the received respective UHF channels 30 will also be present. It is further also clear that the relative variation in transmission distance, signal path, etc. for respective signals received by signal sources such as for example a satellite dish from different satellite transponders is lower than that of such different terrestrial UHF channels 30 which have been received by over the air transmission. It is thus clear that the relative difference in signal level of different UHF channels in the received frequency band of a satellite RF signal will be smaller than for the different UHF channels 30 of a terrestrial RF signal 20.

It is clear that alternative embodiments are possible for the RF signal 20 comprising a plurality of UHF channels 30. In addition to the UHF channels 30 of the RF signal 20, the RF signal 20 could for example also comprise a VHF frequency range comprising a plurality of VHF channels. As further shown, in addition to the terrestrial UHF or VHF frequency range the RF signal could for example also comprises an intermediate frequency or IF satellite signal, which was for example a downconverted satellite signal to a frequency range of 950 MHz to 2150 MHz by means of a low noise block downconverter or LNB. However, it is clear that, preferably, at least one of the RF signals 20 received by the device 10 comprises a plurality of UHF channels 30.

It is clear to a person skilled in the art that for example in the context of UHF television broadcasting by terrestrial UHF RF signals 20 by over the air transmission 16 of terrestrial television broadcasting stations 14, such RF signals for example make use of UHF channels for analog and/or digital television broadcasts. Such UHF channels 30 are typically given channel numbers for identification. For example, in the US UHF channels are numbered 14 to 83, and VHF channels 2 to 13. It is clear to a person skilled in the art that a number of former UHF channels in the upper range of the UHF frequency range have been re-designated for other uses and are no longer used for over the air transmission of such UHF channels by means of such terrestrial RF signals. For example, Channel 37 was never used in the US and some other countries in order to prevent interference with radio astronomy. In 1983, the US FCC removed channels 70 through 83 and reassigned them to Land Mobile Radio Device. In 2009, when the move to digital television was completed in the US, channels 52 through 69 were reallocated as the 700 MHz band for cellular telephone service, and In 2011, Channel 51 was removed to prevent interference with the 700 MHz band. In the US, currently only UHF channels numbered 14 through 36 and UHF channels numbered 38 through 50 are in active use for terrestrial RF signals 20. It is clear that such numbers associated with particular UHF channels could vary from country to country and/or amongst different regions. For example, in the UK and some other European countries, the UHF channels ranged from number 21 through 69. In a European context after an initial reduction of the UHF channels removing use of channels 60 through 69, the UHF channels in active use are planned to be further reduced to number 21 through 48, in function of the rollout of LTE or Long Term Evolution wireless data communications technology which is developed under the GSM/UMTS standards.

As further shown, according to the embodiment of Figure 2, preferably the controller 60 is further configured to trigger a channel memory clear routine 90. For example, the channel memory clear routine 90 is triggered by means of a suitable input element 24, such as for example a suitable button, switch, key, etc. allowing for input by an operator. This input element 24, for example provides a suitable channel memory clear signal 92 to the controller 60, which then triggers the channel memory clear routine 90. During such a channel memory clear routine 90 the channel configuration data 80 is cleared and/or set to be cleared from the channel configuration memory 100 upon reception of this channel memory clear signal 92. Such an embodiment is advantageous, as, for example the automatic scan routine will be triggered at the first power up of the device 10, for example during initial test of the device 10 at the manufacturing site. When this initial power up at the manufacturing site automatically triggers the automatic scan routine 70 which stores channel configuration data 80 in the channel configuration memory 100, then, subsequently, when installed at the housing unit where the device 10 will be put in operation, no further automatic scan routine 70 would be triggered as there is already channel configuration data 80 from a previous automatic scan routine 70 present in the channel configuration memory 100. According to this embodiment, it thus becomes possible to perform the test of the automatic scan routine 70 at the manufacturing site, after which, preferably the channel memory clear routine 90 can be triggered by means of the channel memory clear signal 92, thereby removing any channel configuration data 80 from the previous automatic channel scan routine 70 again from the channel configuration memory 100. When the device 10 is then installed at the housing unit where it will be put in operation, then, when it is powered up the channel memory check routine 72 will trigger the automatic scan routine 70 as the channel configuration memory 100 does not comprise any channel configuration data 80 generated during the previous automatic scan routine 70. In this way the device 10 can be installed and will perform the automatic channel scan routine 70 automatically at its first power up, without the need for any further intervention or manipulation of the operator installing the device 10 and/or the end user.

As further shown, according to the embodiment of Figure 2, preferably the device 10 further comprises a non-volatile storage memory 110 comprising the channel configuration memory 100. In this way the channel configuration data 80 can be retained in an unpowered state, thereby not necessitating a new automatic scan routine 70 at the next power up of the device 10. It is clear that the non-volatile storage memory 110 is operatively coupled to the controller 60. Such a non-volatile storage memory 110 could for example be a suitable flash memory, battery backed up memory, or any other suitable of non-volatile memory. Further, according to the embodiment shown, the device 10 further also comprises a working memory 120 operatively coupled to the controller 60. As shown, the working memory 120 stores a copy of the channel configuration data 130 for use by the controller 60 during generation of the output signal 40. This working memory 120 could for example be a suitable volatile memory, such as for example random access memory, etc. or alternatively suitable non-volatile memory. Although the working memory 120 and the non-volatile storage memory 110 could be embodied as two different types of memories residing in different components, it clear that alternatively the working memory 120 and the non-volatile storage memory 110 could also reside in the same non-volatile memory component suitably coupled to and/or at least partly comprised within the controller 60 of the device 10. As will be described below, such a configuration allows for additional flexibility as the controller 60 makes use of a copy of the channel configuration data 130 for the generation of the output signal 40, thereby allowing for modifications of the channel configuration data 80 stored in the non-volatile storage memory 110, for example by an automatic channel scan routine 70 or a channel memory clear routine 90, while the device 10 is in operation and the controller 60 is still making use of the copy of the channel configuration data 130 for the generation of the output signal 40. It is clear that the copy of the channel configuration data 130 stored in the working memory 120 is a suitable copy of the channel configuration data 80 stored in the non-volatile memory 110 for use during the generation of the output signal 40.

According to one such optional embodiment, when the controller 60 receives a channel memory clear signal 92 it triggers an embodiment of the channel memory clear routine 90 that allows for a subsequent new automatic scan routine 70 to be triggered at a next power up of the device 10, while the device 10 continues to output the output signal 40 based on the copy of the channel configuration data 130 in the working memory 120. According to such an embodiment the channel memory clear routine 90, when triggered, clears or sets the channel memory to be cleared of channel configuration data 80, thereby removing the channel configuration data 80 from the channel configuration memory 100 in the non-volatile storage memory 110, but the copy of the channel configuration data 130 in the working memory 120 is retained, thereby allowing the controller 60 to continue the generation of the output signal 40. Then at a next power up, the controller 60 of the device will detect no channel configuration data 80 in the channel configuration memory 100 stored in the non-volatile storage memory 110, which will automatically trigger the automatic channel scan routine 70 upon which new channel configuration data 80 will be stored in the channel configuration memory 100. This new channel configuration data 80 is then copied to the working memory 120 and this new copy of the channel configuration data 130 is then used by the controller for the generation of the output signal 40.

It is however clear that alternative embodiments of the memory clear routine are possible, which for example force an immediate triggering of the automatic scan routine 70, without the need to await the next power up of the device 10. According to such an embodiment, such as for example shown in Figure 2, the controller 60 could for example receive a forced channel memory clear signal 94, for example similarly input by means of the input element 24, or by any other suitable means. Upon receipt of such a forced channel memory clear signal 94 the controller 60 will trigger a forced channel memory clear routine 96. This forced channel memory clear routine 96 performs the step of triggering the automatic scan routine 70, which will generate and store new channel configuration data 80 in the channel configuration memory 100. The forced channel memory clear routine 96, will also perform the step of replacing the copy of the channel configuration data 130 in the working memory 120 with the new channel configuration data 80 of the channel configuration memory 100. This then allows the controller 60 to generate the output signal 40 with the new channel configuration data 80 immediately.

According to the embodiments mentioned above, the controller 60 receives the channel memory clear signal 92 and/or the forced channel memory clear signal 94 from a suitable input element 24 of the device 10. It is however clear that alternative embodiments are possible in which for example the channel memory clear signal 92 and/or the forced channel memory clear signal 94 is received from two or more input elements of the device 10. According to still further embodiments the signals 92, 94 could be signals, such as suitable control signals, received from a device, such as a receiver device 200, end user device 202, etc. when coupled to the device 10. According to a particular embodiment such a control signal could for example be received from a receiver device 200, end user device 202, etc. via the output connector 42, however it is clear that according to alternative embodiments such a control signal could be received via any other suitable connector of the device 10, for example a dedicated connector for receiving such control signals. According to still alternative embodiments these signals could be received from a suitable remote device 210 via a network, preferably a low power wide area network. According to such an embodiment, as for example shown in Figure 2, a new automatic channel scan at the next power up of the device 10 or a forced immediate automatic channel scan could be triggered by a remote device 210, which is for example coupled via a suitable low power network, such as for example a low LORA network to a suitable connector 26 of the device 10 for providing these signals 92, 94 to the controller 60. The remote device 210 could for example be a suitable server or controller operated by a broadcasting authority, or a device manufacturer, to enable installed devices to execute a new automatic channel scan when for example changes occur with respect to the configuration of the channels of the RF signals being broadcasted.

According to an advantageous embodiment the radio frequency signal processing device 10 is configured to generate the channel memory clear signal 92 and/or the forced channel memory clear signal 94 without the need of any input elements and/or connectors or other additional hardware input elements for generating and/or sending such signals to the controller. This allows an embodiment of the device 10 in which for example next to the input connectors 22 and output connectors 42, no other elements are required, especially input elements for allowing user input. This allows for a robust and simple embodiment of the device 10, which can be installed for example in remote locations in the housing unit, without the need for manipulation of input elements on the device. According to such an embodiment the channel memory clear signal 92 and/or the forced channel memory clear signal 94 can be generated by means of a predetermined power cycle pattern. This means by powering up and powering down the device 10 according to a predetermined pattern. In other words, such a power cycle pattern comprises a predetermined pattern of a plurality of predetermined power up and/or power down cycles of the device 10. This is especially advantageous for embodiments where the device 10 is powered via the output connectors 42, as for example described in more detail above. In this way, the power cycle pattern can be generated remote from the device 10, for example at the location of the device 200, 202 coupled to the output connector for receiving and/or distributing the output signal 40, by for example providing power to the cable coupled to the output connectors 42 according to the predetermined pattern of the power cycle pattern. According to a particularly simple embodiment, this could be realized by powering up and down the device 200, 202 coupled to this cable and providing power via this cable, in accordance with this pattern, or by coupling and uncoupling this cable to the device 200, 202 when powered in accordance with this pattern, etc. Such a power cycle pattern could for example comprise a predetermined number of sequential power ups and power downs of the device within a predetermined time period, such as for example three or more consecutive power ups and power downs within a time period of one minute. However, it is clear that alternative embodiments are possible in which the power cycle sequence comprises a predetermined pattern of power ups and downs which need to be performed in accordance with a predetermined sequence, number and/or timing, etc. of the power up and power down cycles. It is thus clear that in this way, even when the device 10 does not comprise any input element 24 configured to be manually operated, that such signals for the controller 60 can be generated, even at remote locations from the device 10, when it is powered via the output connectors 42.

However, it is clear that still further alternative embodiments are possible, in which for example the device 10 itself is directly powered by means of a suitable power supply, and/or is provided with a suitable power switch or button, whereby the power cycle pattern can be executed for triggering the channel memory clear signal 92 and/or the forced channel memory clear signal 94. It is further clear that a plurality of different power cycle patterns could be detected in this way by the device 10 for triggering a plurality of corresponding different signals 92, 94 for the controller 60.

Although, according to the embodiment shown in Figure 1 and Figure 2, the device 10 comprises three input connectors 22 and a single output connector 42, it is clear that alternative embodiments are possible in which the device 10 comprises at least one input connector 22 and at least one output connector 42 configured to output at least one corresponding output signal 40. Preferably, according to such embodiments, the device 10 is configured to receive power via the at least one output connector 42 from a device 200, 202 when coupled to said output connector 42. Or in other words, preferably the device 10 is remotely powered via the output connector 42.

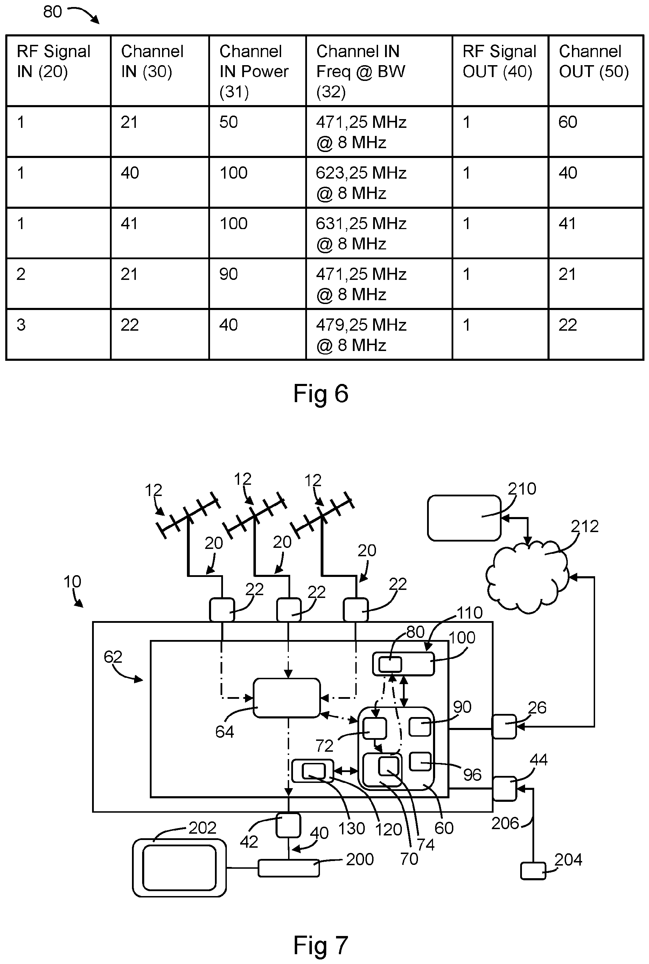

As will be explained in further detail by means of Figure 5A to Figure 5D and Figure 6, with reference to the embodiment of Figure 1 and Figure 2, according to a preferred embodiment of the device 10, especially when the device 10 receives a plurality of terrestrial RF signals 20, the automatic scan routine 70 for example comprises a collision resolution routine 74 to handle colliding channels 32 in different RF signals 20. In other words, according to such an embodiment the automatic scan routine 70 will trigger a collision resolution routine 74 when a plurality of colliding channels 32 is detected at a same channel location 34 in a plurality of radio frequency signals 20 received by the device 10. Figure 5A to 5C for example show embodiments of the three RF signals 20 received by the device 10. According to the embodiment shown, these three signals are terrestrial UHF signals 20 comprising one or more UHF channels 30. As shown in Figure 5A the first RF signal 20 comprises three UHF channels located at UHF channel number 21, 40 and 41. The second RF signal 20 shown in Figure 5B comprises a single UHF channel located at UHF channel number 21 and the third RF signal 20 shown in Figure 5C comprises a single UHF channel located at UHF channel number 22. When the automatic scan routine 70 is triggered at power up of the device 10, it will detect the channels 30 in these three RF signals and will subsequently generate channel configuration data 80 similar to the table shown in the embodiment shown in Figure 6 for storage into the channel configuration memory 100.

As shown in the table of Figure 6, the channel configuration data 80 could for example be represented in the following way. According to the embodiment shown, the channel configuration data of each detected channel 30 in the RF signals 20 is represented in a row of the table. The first column shows an identifier of the input connector 12 receiving the RF signal 20. So the first RF signal 20 of Figure 5A as for example received via the first input connector is represented by identifier "1", the second RF signal 20 of Figure 5B by "2" and the third RF signal 20 of Figure 5C by identifier "3". The second column shows an identifier for the detected channel 30 in these RF signals 20, according to the embodiment shown this identifier corresponds to the UHF channel number of the detected UHF channel 30 in the respective RF signals 20. As shown, in Figures 5A and 5B and the corresponding rows of the table both these RF signals 20 comprise a detected UHF channel 30 at channel number 21. Such channels 30, which are at a single channel location 34 in a plurality of RF signals 20 are referred to as colliding channels 32. Although according to the embodiment shown, there is only one pair of colliding channels 32 at a single channel location 34, it is clear that according to alternative embodiments it is possible that there are a different number of colliding channels 32 at any plurality of channel locations 34. As shown, the third column of the table shows an identifier of the power level of the detected channels 30, which could for example be a numerical indicator of the percentage of a desired reference power level 41 for channels 50 in the output signal 40, however it is clear that alternative embodiments are possible. It is clear that, as shown, different channels 30 and/or channels 30 of different RF signals 20 are typically received at differing power levels 31 as explained in more detail above.

The fifth column of the table, as shown, represents an identifier for the output connector 42 of the output signal 40 to which the detected channel 30 will be output as part of a set of output channels 50 of the output signal 40. It is clear that, as the embodiment shown in Figure 1 and 2 only comprises a single output connector 42, that the identifier "1" is equal for all channels 30, however, according to alternative embodiments with a plurality of output connectors 42 for a plurality of output signals 50, there could be a corresponding plurality of different identifiers available, and each detected channel 30 could be assigned to one or more of these output connectors 42. The fifth and last column of the table shows the frequency at which the detected channel 30 will be output in the set of channels 50 in the output signal 40. As shown, UHF channel "40" of RF signal "1", UHF channel "21" of RF signal "2" and UHF signal "22" of RF signal "3" will remain at the same UHF channel frequency indicated by an identical UHF channel number. However, it is clear that alternative embodiments are possible in which such channels 30 of the RF signals 20 received at the device 10 are provided at any desired frequency in the set of channels 50 of the output signals 40. This is for example realized by means of a suitable signal processing module 64 of the signal processing circuit 62, for example comprising a plurality of digital channelizers such as for example known from WO2017207274, and in addition to adjusting the frequency of the detected channels by means of frequency translation, is preferably also configured to adjust the power level of the detected channels 30, so that the channels 50 in the output signal 40 all comprise a desired more uniform power level 41 for further distribution. This could for example be realized by controlling an automatic gain component of the signal processing module 64 in function of the power levels of the channels 60 as present in the channel configuration data 80. According to the embodiment shown in Figures 5A to Figure 6, the collision resolution routine 74 is configured to generate channel configuration data 80 such that the two colliding channels 32 at a single channel location 34 "21" in the radio frequency signals 20 "1" and "2" are provided at different channel locations 54 "21" and "60" of the set 52 of channels 50 of the output signal 40. Preferably, according to the embodiment shown, the collision resolution routine 74 allocates at least one of the colliding channels 32 to an unused or deprecated channel location in the output signal 40, such as for example the no longer used UHF channel 60 according to the embodiment shown.

Although in the embodiment described above, for the sake of simplicity, use has been made of UHF channel numbers to identify the detected channels 30 during the automatic scan routine 70 , it should be clear that preferably the controller 60 is configured to detect the bandwidth and centre frequency 32 of each of the radio frequency channels 30 of two or more of the radio frequency signals 20 received by the device 10 during the automatic scan routine 70 as schematically shown in the fourth column of the table labelled "Channel IN Freq @ BW". As shown in the first row, there is detected a UHF channel at a centre frequency of 471,25 MHz with a bandwidth of 8 MHz, a further one at 623,25 MHz with a bandwidth 8 MHz, and a third one at 631,25 MHz @ 8 MHz with a bandwidth. In this way, it is clear that the automatic scan routine is preferably not limited to a limited scan of the presence of a predetermined list of predetermined channels. This is advantageous as different geographic regions have different allocations for predetermined lists of channels of such RF signals, and changes to such predetermined lists of channels of such RF signals happen at different times in different regions. In this way the device can be used efficiently in a large number of different geographic regions and is able to cope with any future changes to future transmission plans for the broadcasted RF signals in a simple and reliable way. As for example known to the person skilled in the art, there are for example in operation different terrestrial television broadcasting systems in different geographic regions of the world, which are for example designated by means of ITU standards A - M. These specific standards, each comprise a predetermined channel bandwidth, which could for example be 6 MHz, 7 MHz, 8 MHz, depending on the specific standard. In addition to the ITU standard used. Further, different VHF and UHF channel band plans are in operation. According to a preferred embodiment, the radio frequency signal processing device 10 is configured to detect the bandwidth and/or centre frequency of a plurality of the radio frequency channels 30 of one or more of the radio frequency signals 20 during the automatic scan routine 70. This can then be used to determine the channel spacing and/or the corresponding frequency plan and/or the corresponding ITU Region based on the detected bandwidth and/or centre frequency of a plurality of the radio frequency channels 30. In the example shown in Figures 5A - D and the table of Figure 6, this could for example mean that the system 10 upon detecting the centre frequencies and/or the bandwidth of the detected channels in the first radio frequency signal 20 is able to ascertain that the channel spacing is 8MHz and that the ITU region and channel plan, based on these detected channels corresponds to that of Western Europe, whereby for example the corresponding ITU channel number can be provided in the second column. It is clear that the bandwidth and/or channel spacing can be most easily detected, when adjacent channels, such as Channel "40" and "41" in the first RF signal 20 of the table of Figure 6 are detected, as it corresponds to the distance between the centre frequencies and/or the detected bandwidth of the channels. However, it is clear that the detection of a plurality of non-adjacent channels, such as for example channel "21" and channel "40" also allow for the detection of the channel spacing, as for example the distance between the centre frequencies will be an integer multiple of the channel spacing, which is to be selected from a predetermined set of bandwidths or channel spacings in use internationally at that particular centre frequency and/or in that particular frequency range, such as for example the VHF or UHF frequency domain, such as for example from the set of 6 MHz, 7MHz, 8MHz or 9MHz. For these two channels the difference between both centre frequencies is 152MHz, which is only an integer multiple of 8MHz and thus the channel spacing can be determined in this way. This then allows the radio frequency signal processing device 10 to generate an output signal of which the channel spacing and/or the frequency plan is equal to and/or compatible with said determined channel spacing and/or the corresponding frequency plan and/or the corresponding ITU Region. This is important as the receiver devices operating in such regions will typically be only able to receive and process output signals that are compatible with the channel spacing, frequency plan and/or ITU region in operation in that geographic region. It is clear that in this way, the device 10 can be put in operation in a flexible way, without the need for prior knowledge about its intended geographic location of use, and/or can be used in a flexible way, for example in mobile applications which frequently operate in different geographic regions.

It is thus clear that the device 10, in this way, will preferably be able to generate one or more output signals 40 comprising a set of the detected radio frequency channels 30 originating from the two or more radio frequency signals 20 according to any desired output channel plan. In other words, as for each of the detected channels, the centre frequency and the bandwidth is known from the automatic scan routine 70, it will be possible to calculate a desired arrangement of these detected channels in the output signal in the most flexible way, for example in function of the capabilities of a receiver device coupled to an output connector 42 of the device 10. In other words, preferably, during the automatic scan routine 70, a predetermined frequency range, for example the UHF and/or VHF frequency range is scanned for the presence of RF channels 50, and not just a predetermined set of predetermined RF channels 50 at predetermined centre frequencies with a predetermined bandwidth.

Figure 7 shows an alternative embodiment of the device 10, similar to the embodiments described above. Similar elements are indicated by similar references and function in a way similar as described above. As shown, different from the embodiment of Figure 1, according to this alternative embodiment, and as already mentioned above, the device 10 is suitably coupled to a power supply 204 for receiving power 206 via a power supply connector 44. It is clear that any of the embodiments of the system and method described above, in which the channel memory check routine 72 is triggered when the device 10 is powered up, similarly apply when the device 10 is powered up via power 206 supplied via the power supply connector 44. Different from the embodiment described above, the embodiment of Figure 7, as shown, the radio frequency signal processing device 10 does not comprise any input element 24 configured to be manually operated. According to such an embodiment, similarly as described above, preferably the radio frequency signal processing device 10 is configured to generate the channel memory clear signal 92 and/or forced channel memory clear signal 94 by means of a predetermined power cycle pattern comprising a predetermined pattern of a plurality of predetermined power up and/or power down cycles of the radio frequency signal processing device 10. It is clear that according to such an embodiment the power cycle pattern will be generated by means of the power supplied via the power supply connector 44 to the device 10, for example by means of plugging the power supply 204 in and out according to the predetermined pattern, or switching the power supply 204 on and off according to the predetermined patter, etc. It is clear that also here alternative embodiments are possible, in which for example, the controller 60 receives the channel memory clear signal 92 and/or the forced channel memory clear signal 94 from suitable signals received from a receiver device via an output connector 42 or from a suitable remote device 210 via a network 212 for example via a suitable network connector or interface 26.

It is clear that, according to the embodiment shown in Figure 7, the device 10 does not comprise any input element 24 configured to be manually operated. More specifically it does not comprise an input element 24 such as for example buttons, keys, switches, a touch screen, etc. configured to be manually operated by an operated for the generation of channel memory clear signal 92 and/or forced channel memory clear signal 94. Such an embodiment simplifies the design of the device 10, thereby making it more robust and for example simplifying the accommodation of the device in a housing that can withstand desired levels of temperature variations, moisture levels, etc. It is thus clear that, according to such a particular embodiment the channel memory clear signal 92 and/or the forced channel memory clear signal 94 are only generated by means of a suitable power cycle pattern and/or by means of a suitable signal received via a suitable output connector 42 or network interface 26.

It is clear that, according to such an embodiment as shown in Figure 7, the device 10 could still comprise suitable output connectors 42, which are also configured to receive power for powering the device 10, such as for example already described above in which the device 10 is part of a television signal distribution system, and receives power from a receiver device via a coaxial cable coupled to an output connector 42, or alternatively via an ethernet cable which is provided with power from a device via a suitable system such as for example known as power over ethernet or similar, etc. However it is clear that such an embodiment is also suited for a device comprising output connectors for outputting signals which are not capable of receiving power from a couple receiver device, such as for example output connectors for outputting optical output signals to a coupled optical cable, output connectors for outputting wired or wireless network signals which are not capable of receiving power for powering the device 10, etc.

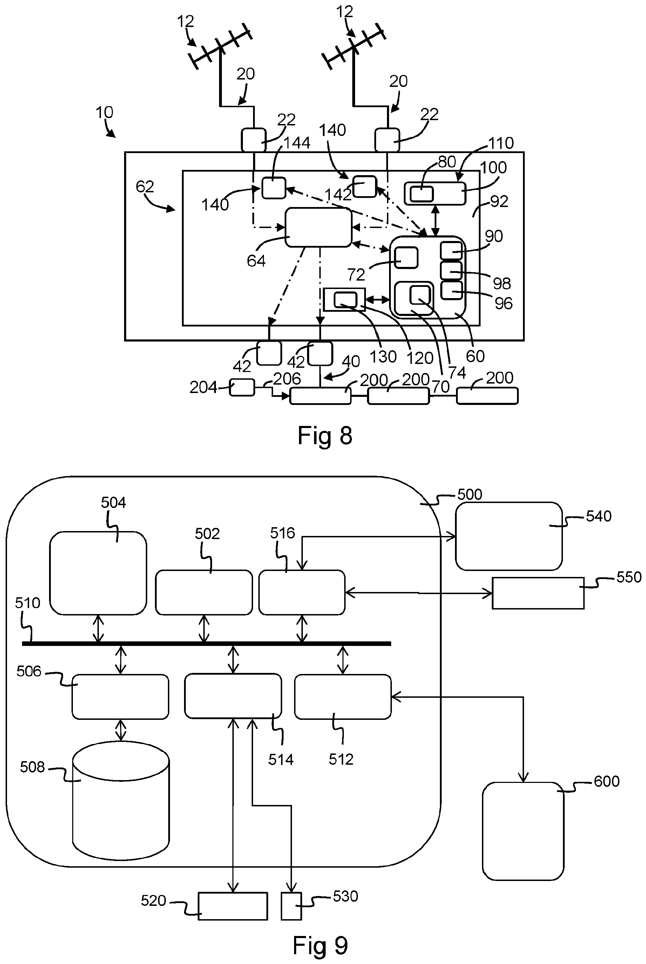

Figure 8 shows a further alternative embodiment of a radio frequency signal processing device 10, similar to the embodiments described above. Similar elements have been indicated by means of similar references and function generally in a similar way as described above. Similar as described above, with reference to the embodiment of Figure 7, it is clear that the embodiment shown does not comprise any input elements 24. Further, as shown, the embodiment also does not comprise a network connector or interface 26. However, it is clear that alternative embodiments are possible in which these elements are present. As further shown in Figure 8, according to this embodiment, there are provided two input connectors 22 for receiving two RF signals 20. Further, also different from the embodiments shown above, the device 10 comprises two output connectors 42 for outputting output signals 40. It is however clear that also here alternative embodiments are possible, in which there are provided a different number of input and output connectors, preferably a plurality of input connectors 22 and at least one output connector 42.

As further shown the controller 60 further comprises, for each input connector 22 of the RF signals 20, an antenna alignment feedback output element 142, 144 which is configured to generate an antenna alignment feedback signal 140. As shown, according to this embodiment, the antenna alignment feedback output elements 142, 144 are suitably coupled to the controller 60 which comprises an antenna alignment feedback routine 98. This antenna alignment feedback routine 98 is configured to generate the antenna alignment feedback signals 140 for the antenna alignment feedback output elements 142, 144. The antenna alignment feedback signals 140 are generated such that they indicate the power level and/or changes to the power level of at least one detected radio frequency channel 30 of the received radio frequency signals 20. According to the embodiment shown, this means that, when the antenna alignment feedback routine 98 has been triggered, the first antenna alignment feedback output element 142 will generate a signal indicative of the power level and/or changes of the power level of at least one RF channel 30 of a first received RF signal 20 at a first input connector 22. The second antenna alignment feedback output element 144 generates then a signal indicative of the power level and/or changes thereof of at least one RF channel 30 of the second received RF signal 20 at the second input connector 22. According to particular embodiments the output element 144, 142 could output the signal in any suitable form, such as for example any suitable visual, auditory, etc. output of the power level and/or changes thereof, such as for example a led bar, led colour change, user interface display element indicative of the power level, numerical indicator of the power level, an auditory signal of which the volume, frequency, pulsation, etc. changes in function of the power level, etc. According to a preferred embodiment, the antenna alignment feedback routine 98 is configured to generate the output signals in function of the power level of at least one desired radio frequency channel of the respective radio frequency signal. This desired radio frequency channel could for example be the one, two or more radio frequency channels of the received radio frequency signal as for example detected during the automatic channel scan routine that comprise the highest power level of the detected channels. The antenna alignment feedback routine 98, then allows an operator to manipulate the terrestrial receiver antenna 12 of the corresponding RF signal 20 and for example thereby adjust its angular position, whereby an increase or decrease of the power level as indicated by the antenna alignment feedback signal 140 can be monitored by the operator in order to hone in on a more optimal antenna positioning in which the power level of the monitored at least one desired RF channel 30 is maximized. It is clear that according to still further embodiments, instead of selecting one or more radio frequency channels 30 with the highest power level as the desired radio frequency channels for the antenna alignment feedback routine 98, the selection of the one or more desired radio frequency channels 30 for the antenna alignment feedback routine 98 could for example be performed by means of a suitable input from the operator. Determining the power level of a desired subset of the radio frequency channels 30 of a radio frequency signal 20 is preferred, as different radio frequency channels 30 of a single radio frequency signal 20 could for example be broadcast from different terrestrial radio frequency antenna at different geographical locations, thereby complicating reliable antenna alignment when monitoring the power level of the received RF signal in its entirety. When monitoring the power level, of a desired subset of radio frequency channels 30, preferably one radio frequency channel 30, of which it is known that it is broadcasted from a single terrestrial broadcasting antenna, antenna alignment with this single terrestrial broadcasting antenna can be performed in a more reliable way. Selecting as the desired RF channel 30, the detected RF channel 30 with the highest power level during an automatic channel scan routine 70, allows for the antenna alignment to be performed most reliably, whereby the signal level of this RF channel 30 is maximized, thereby allowing for the highest dynamic range for all received RF channels 30 of the RF signal 20. It is however clear that alternative embodiments are possible to the one shown in Figure 8. For example, instead of a single output element 142, 144 for each RF signal 20, one or more output elements could be used in a shared way for a plurality of RF signals 20. The controller 60 could for example be configured to generate the antenna alignment feedback signal 140 for a first selected RF signal 20 thereby allowing antenna alignment for this first RF signal and subsequently for another selected RF signal 20 then allowing antenna alignment for this further RF signal, etc. In general, according to such an embodiment the radio frequency signal processing device 10 is further configured to output at least one antenna alignment feedback signal 140. The controller 60 is then configured to trigger an antenna alignment feedback routine 98 during which at least one antenna alignment feedback signal 140 is output. This at least one antenna alignment feedback signal 140 being configured to indicate the power level and/or changes to the power level of at least one detected radio frequency channel 30 of at least one of the received radio frequency signals 20. According to particular embodiments, the antenna alignment feedback routine 98 could be performed constantly, automatically, during a predetermined time period, etc. According to a preferred embodiment the antenna alignment feedback routine 98 is triggered by the controller after performing an automatic channel scan routine 70. Still preferably, according to a particular embodiment, after triggering the antenna alignment feedback routine 98 after a first automatic channel scan routine 70, and monitoring changes to the power level of the desired channels 30 during the antenna alignment feedback routine 98, there could be triggered a further automatic channel scan routine 70, as it could be possible that a more optimized antenna alignment resulting from the antenna alignment feedback routine 98 results in the detection of previously undetectable RF channels 30 in the RF signal 20. Although according to the above-mentioned embodiments, the antenna alignment feedback routine generates a signal indicative of the power level and/or changes of the power level, it is clear that alternative suitable signal parameters could be used to enable a suitable signal for the antenna alignment feedback routine, such as for example a signal indicative of the signal quality and/or changes of the signal quality of at least one detected radio frequency channel 30 of at least one of the received radio frequency signals 20, such as for example the signal to noise ratio or SNR, bit error rate or BER, Modulation error rate or MER, etc. It is clear that according to particular embodiments also a suitable combination and/or plurality of such suitable signal parameters could be used for generating a suitable signal for enabling an antenna alignment feedback routine.

Figure 9 shows a suitable computer system 500 for implementing the controller 60 or the method and/or suitable controllers for the system as described above. The computer system 500 may in general be formed as a suitable computer system, such as for instance an industrial computer system, a micro-controller system, a system on chip, etc. and for instance comprises a bus 510, a processor 502, a local memory device 504, one or more optional input interfaces 514, one or more optional output interfaces 516, a communication interface 512, an interface for storage elements 506 and one or more storage elements 508. Bus 510 may comprise one or more guides allowing communication between the various components of the computer system. Processor 502 may comprise a generally known type of processor or microprocessor interpreting and executing programming instructions. Local memory device 504 may comprise a random access memory (RAM) or another suitable type of dynamic memory storage device storing information and instructions for execution by the processor 502 and/or a read only memory (ROM) or another suitable type of static memory storage device storing information and instructions for use by the processor 504. Input interface 514 may comprise one or more interfaces for receiving signals from an input element such as for instance a sensor, operation interfaces, etc., however it may also comprise one or more conventional mechanisms allowing the operator to enter information in the computer system 500 such as for instance a keyboard 520, a mouse 530, etc. Output interface 516 may comprise one or more output mechanisms for controlling for instance actuators, elements for displaying messages or warning signals, etc., however it may also comprise conventional mechanisms displaying output information to the operator, such as for instance a display 540, a printer 550, a speaker, etc. Communication interface 512 may comprise a suitable transceiver mechanism, such as for instance industrial or conventional network interfaces allowing the computer system 500 to communicate with other devices or systems for instance with one or more other computer systems 600 for instance of the apparatus itself, of other devices or of a management system. The communication interface 512 of computer system 500 may for instance be connected in a suitable manner with a communication network such as for instance a local area network (LAN) or a wide area network (WAN), such as for instance the internet. The interface for storage elements 506 may comprise a known storage interface such as a Serial Advanced Technology Attachment (SATA) interface or a Small Computer System Interface (SCSI) for connecting bus 510 to one or more storage elements 508, such as for instance local drives, for instance 1TB SATA hard drives, and for controlling, reading and writing of data to and/or from these storage elements 508. It is clear that alternative storage elements 508, generally any suitable computer readable medium such as for instance a removable magnetic drive, SSDs, flash-based storage devices, optical drives, ROM drives, etc. can be used. Furthermore, it is also clear that network-based storage means can be accessed via the network interface. The embodiments of the method and system and/or device as described above, can be implemented as programming instructions that are loaded into the local memory device 504 of computer system 500 for execution by its processor 502. Said programming instructions can for instance be loaded from a storage element 508 or be made accessible from another computer system 600 through the communication interface 512.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A radio frequency signal processing device (10) configured to:
- receive at least one radio frequency signal (20) comprising at least one radio frequency channel (30); and
- output at least one output signal (40) by processing at least one of the radio frequency channels (30) of at least one of the received radio frequency signal (20) by means of channel configuration data (80),
the device (10) comprising:
- a controller (60) configured to trigger an automatic scan routine (70) during which:
- the radio frequency channels (30) of the at least one radio frequency signal (20) are automatically detected; and
- corresponding channel configuration data (80) is automatically generated for the detected radio frequency channels (30), and
- a channel configuration memory (100) operatively connected to the controller (60) and configured to store the channel configuration data (80) generated during the channel scan routine (70),
**CHARACTERISED IN THAT**
the controller (60) is further configured such that:
- a channel memory check routine (72) is automatically triggered when the device (10) is powered up;
- the channel memory check routine (72) is configured to:
- detect whether the channel configuration memory (100) is clear of and/or is set to be cleared of channel configuration data (80); and
- trigger the automatic scan routine (70) if it is detected that the channel configuration memory (100) is clear of and/or set to be cleared of channel configuration data (80).

2. A radio frequency signal processing device according to claim 1, wherein the radio frequency signal processing device (10) further comprises at least one output connector (42) and is further configured to:
- output said at least one output signal (40), as determined by means of the channel configuration data (80), via said at least one output connectors (42); and
- receive power via at least one of said at least one output connectors (42), and/or
wherein the radio frequency signal processing device (10) is further configured to:
- output at least one output signal (40) comprising a set of the radio frequency channels (50) originating from the at least one radio frequency signal (20) via at least one output connector (42).

3. A radio frequency signal processing device according to any of the preceding claims, wherein the controller (60) is further configured such that:
- the channel memory check routine (72) is further configured not to trigger the automatic scan routine (70) if it is detected that the channel configuration memory (100) is not clear of and/or is not set to be cleared of channel configuration data (80).

4. A radio frequency signal processing device according to any of the preceding claims, wherein the radio frequency signal processing device (10) is configured to:
- detect the bandwidth and/or centre frequency of a plurality of the radio frequency channels (30) of one or more of the radio frequency signals (20) during the automatic scan routine (70); and
- determine the channel spacing and/or the corresponding frequency plan and/or the corresponding ITU Region based on the detected bandwidth and/or centre frequency of a plurality of the radio frequency channels (30).

5. A radio frequency signal processing device according to claim 4, wherein the radio frequency signal processing device (10) is configured to generate an output signal of which the channel spacing and/or the frequency plan is equal to and/or compatible with said determined channel spacing and/or the corresponding frequency plan and/or the corresponding ITU Region.

6. A radio frequency signal processing device according to any of the preceding claims, wherein the controller (60) is further configured to trigger a channel memory clear routine (90) during which the channel configuration data (80) is removed from the channel configuration memory (100) upon reception of a channel memory clear signal (92).

7. A radio frequency signal processing device according to any of the preceding claims, wherein the radio frequency signal processing device comprises, operatively coupled to the controller (60):
- non-volatile storage memory (110) comprising the channel configuration memory (100);
- working memory (120) configured to store a copy of the channel configuration memory (130) for use by the controller (60) during generation of the output signal (40).

8. A radio frequency signal processing device according to claim 7, wherein the controller is configured to:
- upon receipt of a channel memory clear signal (92), trigger a channel memory clear routine (90) configured to:
- remove the channel configuration data (80) from the channel configuration memory (100) in the non-volatile storage memory (110); and
- retain the copy of the channel configuration memory (130) in the working memory (120) thereby allowing the controller (60) to continue the generation of the output signal (40); and/or
- upon receipt of a forced channel memory clear signal (94), trigger a forced channel memory clear routine (96) configured to:
- remove the channel configuration data (80) from the channel configuration memory (100) in the non-volatile storage memory (110); and
- trigger the automatic scan routine (70) thereby generating and storing new channel configuration data (80) in the channel configuration memory (100);
- replace the copy of the channel configuration memory (130) in the working memory (120) with the new channel configuration data (80) of the channel configuration memory (100), thereby allowing the controller (60) to generate of the output signal (40) with the new channel configuration data (80).

9. A radio frequency signal processing device, according to claim 8, wherein the controller (60) is further configured to receive the channel memory clear signal (92) and/or the forced channel memory clear signal (94) from one or more of the following:
- one or more input elements of the radio frequency signal processing device (10);
- one or more signals received from a receiver device (200) when coupled to the radio frequency signal processing device (10);
- one or more signals received from a suitable remote device (210) via a network.

10. A radio frequency signal processing device according to any of the claims 6 to 9, wherein the radio frequency signal processing device (10) is configured to generate the channel memory clear signal (92) and/or forced channel memory clear signal (94) by means of a predetermined power cycle pattern comprising a predetermined pattern of a plurality of predetermined power up and/or power down cycles of the radio frequency signal processing device (10).

11. A radio frequency signal processing device according to any of the preceding claims, wherein the radio frequency signal processing device (10) is configured to receive a plurality of radio frequency signals (20) and in which the controller (60) is configured to generate at least one output signal (40) comprising a set of the detected radio frequency channels (30) originating from the two or more radio frequency signals (20).

12. A radio frequency signal processing device, according to any of the claims 11, wherein, the automatic scan routine (70) is further configured to trigger a collision resolution routine (74) when a plurality of colliding channels (32) is detected at a same channel location (34) in a plurality of radio frequency signals (20), whereby the collision resolution routine (74) is configured to generate channel configuration data (80) such that at least two of the colliding channels (32) at a single channel location (34) in the radio frequency signals (20) are provided at different channel locations (54) of the set of radio frequency channels (50) of the output signal (40).

13. A radio frequency signal processing device, according to any of the preceding claims, wherein the radio frequency signal processing device (10) is further configured to output at least one antenna alignment feedback signal (140), and wherein the controller (60) is further configured to trigger an antenna alignment feedback routine (98) during which at least one antenna alignment feedback signal (140) is output which is configured to indicate the power level and/or signal quality of at least one detected radio frequency channel (30) of at least one of the received radio frequency signals (20) and/or changes of said power level and/or signal quality.

14. A radio frequency signal processing device, according do any of the preceding claims, wherein the radio frequency signal processing device (10) does not comprise any input element (24) configured to be manually operated, and/or
wherein the radio frequency signal processing device (10) is configured to receive, from two or more terrestrial antennas (12), two or more terrestrial radio frequency (RF) signals comprising a VHF and/or UHF frequency range comprising a plurality of VHF and/or UHF channels with different power levels which have been transmitted over the air by different terrestrial broadcasting stations (14).

15. A method of operating a radio frequency signal processing device (10) according to any of the preceding claims, whereby the method comprises the steps of:
- receiving at least one radio frequency signal (20) comprising at least one radio frequency channel (30);
- automatically triggering an automatic channel scan routine (70) during which:
- the radio frequency channels (30) of the at least one radio frequency signal (20) are automatically detected; and
- automatically generating, for the detected radio frequency channels (30), corresponding channel configuration data (80) to generate at least one output signal (40);
- storing the channel configuration data (80) generated during the automatic channel scan routine (70) in a channel configuration memory (100); and
- outputting the at least one output signal (40) by processing at least one of the radio frequency channels (30) of at least one of the received radio frequency signal (20) by means of channel configuration data (80),
**CHARACTERISED IN THAT**
the method comprises the further steps of:
- triggering a channel memory check routine (72) when the device (10) is powered up;
- the channel memory check routine (72) comprising the steps of:
- detecting whether the channel configuration memory (100) is clear of and/or is set to be cleared of any channel configuration data (80); and
- triggering the automatic scan routine (70) if it is detected that the channel configuration memory (100) is clear of and/or set to be cleared of any channel configuration data (80).
